# FASCICULE DE BREVET EUROPEEN

(11) **EP 4 213 182 B1**
(45) Date de publication et mention de la délivrance du brevet: **11.09.2024**
(21) Numéro de dépôt: 22213953.7
(22) Date de dépôt: 15.12.2022
(51) Int. Cl.: H01L 21/18, H01L 21/20

(54) **PROCÉDÉ D'ACTIVATION D'UNE COUCHE EXPOSÉE**
VERFAHREN ZUR AKTIVIERUNG EINER BELICHTETEN SCHICHT
METHOD OF ACTIVATING AN EXPOSED LAYER

(30) Priorité: 29.12.2021 FR 2114604
(43) Date de publication de la demande: 19.07.2023
(73) Titulaire: Commissariat à l'énergie atomique et aux énergies alternatives, 75015 Paris (FR)
(72) Inventeur: BRIANCEAU, Pierre, 38054 GRENOBLE Cedex 09 (FR); POSSEME, Nicolas, 38054 GRENOBLE Cedex 09 (FR)
(74) Mandataire: Hautier IP

(56) Documents cités:
- US-A1- 2014 174 649
- US-A1- 2015 064 498
- US-A1- 2019 344 533

## Description

### DOMAINE TECHNIQUE

La présente invention concerne le domaine des procédés d'activation d'une surface d'une structure telle qu'un substrat. D'une manière générale, le domaine des dispositifs microélectroniques est visé. Elle trouve pour application particulièrement avantageuse le domaine du collage direct de substrats.

### ETAT DE LA TECHNIQUE

Il est connu de façon générale d'assembler plusieurs substrats par collage direct pour la fabrication de dispositif microélectronique. Pour cela, il existe des solutions mettant en oeuvre un plasma d'activation permettant d'améliorer l'énergie de collage entre les substrats assemblés. Dans ces solutions, la couche exposée d'un substrat est typiquement traitée par un plasma d'activation à base d'oxygène ou d'azote, préalablement à l'assemblage. En pratique, l'énergie de collage obtenue reste trop limitée.

L'injection d'un gaz fluoré, tel que le tétrafluorure de carbone de formule chimique CF₄ ou l'hexafluorure de soufre de formule chimique SF₆ dans un plasma d'activation à base d'oxygène permet d'augmenter l'énergie de collage entre deux substrats assemblés suite à ce traitement. Cette solution s'avère limitée en pratique, notamment en raison d'une gravure de la couche exposée lors du traitement par le plasma d'activation.

Il est notamment connu du document US10434749 B2 un procédé comprenant la formation d'une couche de collage SiOF sur la couche exposée d'un substrat par dépôt chimique en phase vapeur assisté par plasma (Communément abrégé PECVD, de l'anglais *Plasma-Enhanced Chemical Vapor Deposition*)*,* préalablement à l'assemblage du substrat avec un autre substrat. Cette solution reste toutefois améliorable.

Des procédés d'activation de surface sont également connus des documents US 2014/174649 A1, US 2015/064498 A1, et US 2019/344533 A1.

Un objet de la présente invention est donc de proposer une solution visant à améliorer le collage direct sur un substrat, et notamment visant à limiter la gravure de la couche exposée.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé d'activation d'une couche exposée d'une structure comprenant :
- une fourniture d'une structure comprenant une couche exposée,
- un dépôt, sur la couche exposée, d'une couche à base d'un matériau de formule SiₐY_{b}X_{c}, dite couche SiₐY_{b}X_{c}, avec X choisi parmi le fluor F et le chlore CI, et Y choisi parmi l'oxygène O et l'azote N, a, b et c étant des entiers positifs non nuls,
- un traitement de la couche SiₐY_{b}X_{c} par un plasma d'activation à base de l'un au moins parmi de l'oxygène et de l'azote,
et dans lequel les paramètres du dépôt de la couche SiₐY_{b}X_{c} sont choisis de façon à obtenir une densité de matière suffisamment faible pour que la couche SiₐY_{b}X_{c} soit au moins en partie consommée par le plasma d'activation.

Ce procédé permet ainsi de dissocier temporellement la formation d'une couche fluorée et/ou chlorée et l'activation par le plasma d'activation. La consommation de la couche exposée est donc limitée par rapport aux solutions mettant en oeuvre un apport de gaz fluoré dans le plasma d'activation.

La densité de la couche SiₐY_{b}X_{c} plus faible fait qu'il est possible de retirer au moins en partie cette couche par le plasma d'activation pour activer la surface exposée d'un substrat avant collage. L'épaisseur de la couche SiₐY_{b}X_{c} déposée est ainsi réduite par le traitement par le plasma d'activation. De préférence la couche SiₐY_{b}X_{c} est entièrement consommée, préalablement à un assemblage de la structure avec un autre substrat, tout en permettant de modifier chimiquement la surface de la couche exposée pour son activation.

Le retrait au moins partiel, et de préférence total, de cette couche permet d'éviter des modifications des propriétés de l'assemblage après collage, pour son intégration dans un dispositif microélectronique. Les espèces F ou CI, et O ou N, peuvent être implantées uniquement en surface de la couche exposée.

Typiquement, les couches déposées en réacteur de dépôt, par exemple par PECVD, présentent une densité trop forte pour pouvoir être consommées par le plasma d'activation. Pour retirer une couche de SiₐY_{b}X_{c} déposée en réacteur de dépôt, la personne du métier aurait envisagé de retirer la couche SiₐY_{b}X_{c} de façon usuelle par gravure à l'acide fluorhydrique. Toutefois, dans le cadre du développement de la présente invention, il s'est avéré que cette gravure est trop agressive et risque de graver la couche exposée et d'enlever le fluor/chlore en surface de la couche exposée permettant son activation. Le collage subséquent serait donc détérioré.

Un deuxième aspect concerne un procédé de collage d'une couche exposée d'une structure avec une couche exposée d'un substrat distinct, le procédé comprenant :
- l'activation de la couche exposée de la structure en mettant en oeuvre le procédé selon le premier mode de réalisation,
- la mise en contact de la couche exposée de la structure avec la couche exposée du substrat distinct.

De préférence, la couche exposée de la structure avec la couche exposée du substrat distinct sont assemblées par collage direct. Ce procédé présente les effets et avantages du procédé selon le premier aspect. Le procédé de collage permet d'obtenir un assemblage présentant une interface de collage, entre la couche exposée de la structure et la couche exposée du substrat distinct, améliorée par rapport aux solutions existantes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe transversale d'une structure présentant une couche exposée, selon un exemple de réalisation.
La figure 2 représente une vue en coupe transversale de la structure présentant la couche exposée illustrée en figure 1 et la couche à base du matériau de formule chimique SiₐY_{b}X_{c}, selon un exemple de réalisation.
La figure 3 représente, une vue en coupe transversale d'un exemple de traitement par le plasma d'activation de la structure selon l'exemple de réalisation illustré en figure 2.
La figure 4 représente, une vue en coupe de la structure présentant une couche exposée activée, suite à l'exemple illustré par la figure 3.
La figure 5 représente, une vue en coupe d'un assemblage de la structure présentant une couche exposée activée selon l'exemple illustré en figure 4, avec la couche exposée d'un substrat distinct.
La figure 6 représente de manière schématique un exemple de réacteur pouvant être utilisé pour mettre en oeuvre le procédé selon l'invention.
La figure 7 représente un graphique de l'épaisseur de la couche SiₐY_{b}X_{c} déposée en fonction de la puissance de la source radiofréquence du plasma, selon plusieurs exemples de réalisation du procédé.
La figure 8 représente un graphique de l'épaisseur de la couche SiₐY_{b}X_{c} déposée en fonction du débit d'oxygène lors du dépôt, selon plusieurs exemples de réalisation du procédé.
La figure 9 représente un graphique de l'épaisseur de la couche SiₐY_{b}X_{c} déposée en fonction de la pression dans la chambre de réaction lors du dépôt, selon un exemple de réalisation du procédé.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, les paramètres choisis de façon à obtenir une densité de matière suffisamment faible pour que la couche SiₐY_{b}X_{c} soit au moins en partie consommée par le plasma d'activation sont pris parmi les paramètres suivants : la température de dépôt, la pression dans la chambre de réaction et, le dépôt étant assisté par plasma, la puissance d'une source du plasma.

Selon un exemple, les paramètres du traitement de la couche SiₐY_{b}X_{c} par le plasma d'activation sont choisis pour consommer au moins en partie la couche SiₐY_{b}X_{c} déposée de façon à activer la couche exposée de la structure.

Selon un exemple, les paramètres du traitement de la couche SiₐY_{b}X_{c} par le plasma d'activation sont choisis pour consommer au moins au moins 90% de la couche SiₐY_{b}X_{c} déposée et de préférence toute la couche SiₐY_{b}X_{c} déposée. Ainsi, le traitement par le plasma d'activation permet de retirer la couche SiₐY_{b}X_{c} déposée pouvant impacter les propriétés du dispositif microélectronique résultant.

Selon un exemple, le dépôt est configuré de sorte que la couche SiₐY_{b}X_{c} présente une épaisseur inférieure ou égale à 10 nm. Au-delà de 10 nm, une épaisseur plus importante n'a peu voire pas d'impact sur l'énergie de collage. Une épaisseur inférieure ou égale à 10 nm permet donc de limiter le temps et le coût du procédé.

Selon un exemple, le dépôt est configuré de sorte que la couche SiₐY_{b}X_{c} présente une épaisseur supérieure ou égale à 2 nm. Cette épaisseur est suffisante pour bien couvrir la couche exposée et avoir suffisamment de SiₐY_{b}X_{c} pour activer la couche exposée et augmenter l'énergie de collage.

Selon un exemple, le dépôt est configuré de sorte que la couche SiₐY_{b}X_{c} présente une épaisseur de préférence comprise en 2 et 4 nm. Cette gamme d'épaisseur présente un bon compris entre coût et temps du procédé et l'énergie de collage obtenue.

Selon un exemple, le dépôt de la couche SiₐY_{b}X_{c} et le traitement par le plasma d'activation sont réalisés dans la même chambre de réaction. Cela permet de simplifier le procédé, de le rendre moins coûteux et plus aisément reproductible.

Selon un exemple, le substrat est laissé dans la chambre de réaction entre le dépôt de la couche à base d'un matériau de formule chimique SiₐY_{b}X_{c} et le traitement par le plasma d'activation.

Selon un exemple, le traitement par le plasma d'activation comprend l'application d'une tension dans la chambre de réaction, dite tension d'auto-polarisation, de préférence la tension d'auto-polarisation est non nulle. Ainsi, l'énergie des ions du plasma d'activation peut être modulée pour améliorer l'efficacité du bombardement ionique sur la couche SiₐY_{b}X_{c} et donc l'activation de la couche exposée, tout en limitant la gravure de la couche exposée.

Selon un exemple, la valeur absolue de la tension d'auto-polarisation est sensiblement supérieure ou égale à 100 V, de préférence sensiblement supérieure ou égale à 200 V. Selon un exemple, la valeur absolue de la tension d'auto-polarisation est sensiblement inférieure ou égale à 500 V. Selon un exemple, la valeur absolue de la tension d'auto-polarisation est sensiblement comprise entre 100 V et 500 V, de préférence sensiblement égale à 450V.

Selon un exemple, le dépôt de la couche SiₐY_{b}X_{c} comprend l'application dans la chambre de réaction d'une tension, dite tension d'auto-polarisation, inférieure ou égale à 100 V, de préférence comprise entre 0 et 50 V, de préférence aucune tension d'auto-polarisation n'est appliquée durant ledit dépôt. Le bombardement ionique est ainsi limité lors du dépôt de la couche SiₐY_{b}X_{c}, ce qui limite le risque de gravure de la couche exposée.

Selon un exemple, le dépôt de la couche SiₐY_{b}X_{c} et le traitement par le plasma d'activation sont réalisés dans la même chambre de réaction.

Selon un exemple, la structure est fournie dans un réacteur comprenant une chambre de réaction à l'intérieur de laquelle la structure est disposée pour au moins le dépôt de la couche SiₐY_{b}X_{c}, la température dans la chambre étant inférieure ou égale à 100 °C au moins pendant le dépôt de la couche SiₐY_{b}X_{c}, et de préférence sensiblement comprise entre 20°C et 80°C.

Selon un exemple, la structure est fournie dans un réacteur de gravure réactive, le réacteur comprenant une chambre de réaction à l'intérieur de laquelle la structure est disposée pour au moins le dépôt de la couche SiₐY_{b}X_{c}, et de préférence pour le dépôt de la couche SiₐY_{b}X_{c} et le plasma d'activation.

Selon un exemple, le dépôt de la couche SiₐY_{b}X_{c}, et le traitement par le plasma d'activation est réalisé dans une chambre de réaction d'un réacteur plasma à couplage capacitif.

Selon un exemple, le dépôt de la couche SiₐY_{b}X_{c}, et le traitement par le plasma d'activation est réalisé dans une chambre de réaction d'un réacteur plasma à couplage inductif.

Selon un exemple, le dépôt de la couche SiₐY_{b}X_{c} n'est pas réalisé par une technique CVD. Selon un exemple, le dépôt de la couche SiₐY_{b}X_{c} est réalisé par une technique différente d'un dépôt CVD, et en particulier d'un dépôt PECVD. Plus particulièrement, le dépôt est réalisé dans une chambre de gravure ionique réactive (communément abrégé RI, de l'anglais *Reactive Ion Etching*) de préférence à couplage inductif, différent des techniques CVD et PECVD.

Selon un exemple, la couche SiₐY_{b}X_{c} est faite d'un matériau ne comprenant pas de carbone. Selon un exemple, la couche SiₐY_{b}X_{c} est faite d'un matériau de formule SiₐY_{b}X_{c}. Le matériau SiₐY_{b}X_{c} est moins impactant sur les performances du dispositif par rapport à d'autres espèces comme le carbone.

Selon un exemple, lors du traitement par le plasma d'activation, une tension de polarisation V_{bias-substrat} est appliquée à la structure. Ainsi, le bombardement ionique sur la couche SiₐY_{b}X_{c} et la gravure de la couche exposée peuvent être encore mieux contrôlés et de préférence minimisés Selon un exemple, la tension de polarisation V_{bias-substrat} est non nulle. Selon un exemple, la tension appliquée à la structure V_{bias-substrat} est choisie de sorte que la valeur absolue de la tension d'auto-polarisation est comprise entre 100 V et 500 V.

Selon un exemple, la tension de polarisation V_{bias-substrat} appliquée à la structure est pulsée. Cela permet une plus grande fenêtre de paramètres pour minimiser la gravure de la couche exposée tout en permettant son activation.

Selon un exemple, la tension de polarisation V_{bias-substrat} appliquée à la structure et la source du plasma sont pulsées.

Selon un exemple, une tension de polarisation V_{bias-substrat} est appliquée à la structure de façon indépendante à la puissance radiofréquence (RF) de la source du plasma Pₛ₋ₚₗₐₛₘₐ.

Selon un exemple, le dépôt de la couche à base d'un matériau de formule SiₐY_{b}X_{c} est un dépôt chimique à partir d'au moins un précurseur gazeux. De préférence, le dépôt est assisté par plasma. Un dépôt assisté par plasma permet une meilleure conformité et/ou uniformité de la couche SiₐY_{b}X_{c}.

Selon un exemple, l'au moins un précurseur gazeux comprend au moins les éléments silicium, l'un parmi le fluor et le chlore, et l'un parmi l'oxygène et l'azote. De préférence l'au moins un précurseur gazeux étant choisi parmi le groupe constitué de SiF₄ et SiCl₄ en combinaison avec O₂ ou N₂.

Selon un exemple, lors du dépôt de la couche à base d'un matériau de formule chimique SiₐY_{b}X_{c}, la couche exposée n'est pas gravée.

Selon un exemple le plasma d'activation est à base d'azote et/ou d'oxygène.

Selon un exemple, le traitement par le plasma d'activation comprend une injection d'au moins un gaz dans une chambre de réaction d'un réacteur plasma et une formation du plasma d'activation à partir dudit gaz dans la chambre de réaction Selon un exemple, l'au moins un gaz comprend du dioxygène, du diazote, ou leur mélange. Selon un exemple, l'au moins un gaz comprend du dioxygène et/ou du diazote, en mélange avec un gaz neutre tel que de l'hélium et/ou l'argon.

Selon un exemple, le plasma d'activation est exempt d'espèce halogénée et en particulier de fluor et de chlore. Le plasma d'activation peut ne pas comprendre d'injection d'un gaz comprenant d'élément halogène et en particulier l'élément fluor ou chlore dans la chambre de réaction. La gravure de la couche exposée est donc minimisée, voire évitée. Ainsi, ce procédé se différencie clairement des solutions connues consistant à effectuer un traitement par un plasma d'activation avec l'injection d'un gaz comprenant l'élément fluor ou chlore.

Selon un exemple, le plasma d'activation est configuré pour ne pas déposer de couche sur la couche exposée et/ou les parois de la chambre de réaction.

Selon un exemple, la couche exposée est à base d'un semi-conducteur ou d'un métal ou d'un métalloïde. Par exemple la couche exposée est à base ou faite d'un oxyde métallique, par exemple d'un oxyde de semi-conducteur, d'un nitrure métallique, par exemple d'un nitrure de semi-conducteur.

Selon un exemple, la couche exposée est à base de silicium. Par exemple la couche exposée est à base ou faite d'un oxyde de silicium, d'un nitrure de silicium ou de silicium.

Selon un exemple, après le traitement par le plasma d'activation, le procédé peut comprendre l'assemblage de la couche exposée de la structure avec une couche exposée d'un substrat distinct.

Selon un exemple, au moins l'un parmi le dépôt de la couche à base d'un matériau de formule SiₐY_{b}X_{c} et le traitement par le plasma d'activation peuvent être répétés plusieurs fois. Selon un exemple, au moins l'un parmi le dépôt et le traitement par le plasma d'activation peuvent être répétés plusieurs fois avant l'assemblage de la couche exposée de la structure avec une couche exposée d'un substrat distinct. De préférence, le dépôt de la couche à base d'un matériau de formule SiₐY_{b}X_{c} et le traitement par le plasma d'activation forment un cycle pouvant être répété plusieurs fois.

Par dispositif microélectronique, on entend tout type de dispositif réalisé avec les moyens de la microélectronique. Ces dispositifs englobent notamment, en plus des dispositifs à finalité purement électronique, des dispositifs micromécaniques ou électromécaniques (MEMS, de l'anglais *microelectromechanical systems* que l'on peut traduire par systèmes microélectromécaniques, NEMS, de l'anglais *nanoelectromechanical systems* que l'on peut traduire par systèmes nanoélectromécaniques,...) ainsi que des dispositifs optiques ou optoélectroniques (MOEMS, de l'anglais *Micro-Opto-Electro-Mechanical System* que l'on peut traduire par microsystèmes opto-électro-mécaniques,...).

Il peut s'agir d'un dispositif destiné à assurer une fonction électronique, optique, mécanique etc. Il peut aussi s'agir d'un produit intermédiaire uniquement destiné à la réalisation d'un autre dispositif microélectronique.

On entend par « collage direct » un collage sans apport de matière adhésive (de type colle ou polymère notamment) qui consiste en la mise en contact de surfaces relativement lisses (d'une rugosité typiquement inférieure à 5 Å, 10⁻⁹ m), par exemple réalisé à température ambiante et sous atmosphère ambiante, afin de créer une adhérence entre elles.

Selon un exemple, le collage direct de deux substrats signifie que le collage est obtenu par les liens chimiques qui s'établissent entre les deux surfaces mises en contact.

Le collage direct peut être obtenu sans nécessiter l'application d'une pression importante sur la structure à assembler. Une légère pression pourra simplement être appliquée pour initier le collage. Un recuit thermique peut en outre être effectué pour consolider le collage.

On entend par un substrat, une couche, une zone ou une portion « à base » d'un matériau A, un substrat, une couche, une zone ou une portion comprenant ce matériau A, par exemple à hauteur d'au moins 50%, et éventuellement d'autres matériaux, par exemple des éléments dopants.

De manière parfaitement classique, une structure à base d'un oxyde métallique est une structure faite, ou comprenant un matériau comprenant au moins un métal ou un métalloïde et de l'oxygène. Une structure à base d'un nitrure métallique est une structure faite, ou comprenant un matériau comprenant au moins un métal ou un metalloïde et de l'azote.

Le mot « diélectrique » qualifie un matériau dont la conductivité électrique est suffisamment faible dans l'application donnée pour servir d'isolant. Dans la présente invention, un matériau diélectrique présente de préférence une constante diélectrique supérieure à 4.

Il est précisé que dans le cadre de la présente invention, le terme « sur », « surmonte », ou leurs équivalents ne signifient pas forcément « au contact de », sauf mention contraire de « juxtaposé ». Par des couches, ou portions, ou zones « juxtaposés » on entend ici que les couches, ou portions, ou zones sont en contact selon leur plan d'extension principale et disposées les unes au-dessus des autres selon la direction de l'empilement, cette direction étant perpendiculaire au plan d'extension principale. Par « en contact », on entend qu'une fine interface puisse exister, par exemple causée par la variabilité de fabrication.

Dans la description qui suit, les épaisseurs de couche, de zone ou de portion ainsi que les profondeurs sont généralement mesurées selon une direction verticale, parallèle à la direction d'empilement et perpendiculaire au plan principal d'extension du substrat, de la couche, de la sous-couche ou de la portion.

Par ailleurs, un plasma à base d'azote et/ou d'oxygène peut être basé sur une chimie comprenant uniquement de l'azote et/ou de l'oxygène ou comprenant de l'azote et/ou de l'oxygène et éventuellement une ou plusieurs autres espèces, par exemple des gaz neutres (tels que l'hélium ou l'argon par exemple).

Dans la présente demande de brevet lorsque l'on exprime un mélange gazeux avec des pourcentages, ces pourcentages correspondent à des fractions du débit total des gaz injectés dans le réacteur. Ainsi, si un mélange gazeux, par exemple destiné à former un plasma, comprend x % du gaz A, cela signifie que le débit d'injection du gaz A correspond à x % du débit total des gaz injectés dans le réacteur pour former le plasma.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par un paramètre « sensiblement égal/supérieur/inférieur à » une valeur donnée, que ce paramètre est égal/supérieur/inférieur à la valeur donnée, à plus ou moins 10 % près, voire à plus ou moins 5 % près, de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Le procédé d'activation est maintenant décrit à titre non limitatif selon plusieurs exemples de réalisation.

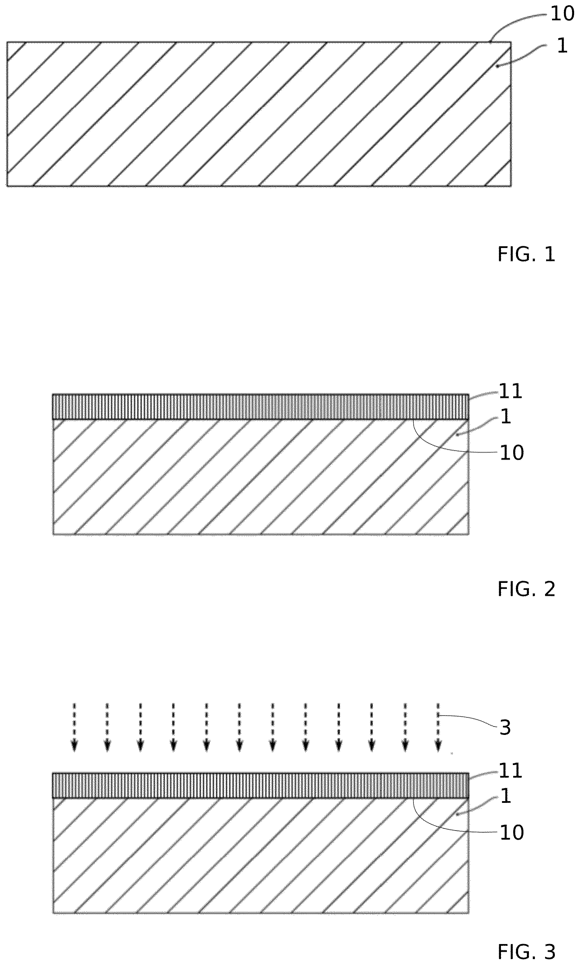

Le procédé est configuré pour activer la couche exposée 10 d'une structure 1, par exemple illustrée par la figure 1. Une telle structure est par exemple à base d'un matériau semi-conducteur. Dans l'exemple non limitatif qui va être décrit en détail, cette structure 1 est à base ou faite de silicium. Cette structure 1 peut être à base ou faite d'un oxyde de silicium, d'un nitrure de silicium ou de silicium. La structure 1 peut être du silicium massif dit « bulk ». Par ailleurs, toutes les caractéristiques, étapes et effets techniques qui seront décrits par la suite sont parfaitement applicables à une structure 1, possiblement autre qu'une couche, telle qu'une nanostructure, par exemple en trois dimensions, ou une pluralité de telles structures.

La structure 1 peut faire partie d'un substrat. Ce substrat peut être formé uniquement de cette structure 1. De manière alternative, ce substrat peut comprendre une couche de support surmontée au moins d'une telle structure 1. La structure présente une couche exposée 10, libre et exposée aux espèces environnantes, par exemple présentes dans la chambre de réaction 20 d'un réacteur 2.

Pour activer la couche exposée 10, le procédé comprend principalement trois étapes : une étape de fourniture de la structure 1, une étape de dépôt et une étape de traitement.

Le procédé comprend le dépôt d'une couche fluorée et/ou chlorée 11 à base d'un matériau de formule chimique SiₐY_{b}X_{c}. X est choisi parmi les éléments fluor F et/ou chlore Cl. Y est choisi parmi les éléments oxygène O et/ou azote N. a, b, c sont des entiers positifs non nuls. La couche fluorée 11 peut par exemple présenter les formules chimiques suivantes : SiₐO_{b}Cl_{c}, SiₐO_{b}F_{c}, SiₐN_{b}Cl_{c}, et SiₐN_{b}F_{c}. Le procédé comprend suite à ce dépôt, le traitement de la couche fluorée et/ou chlorée 11 par un plasma d'activation 3 configuré pour consommer au moins en partie, de préférence totalement, cette couche 11 et ainsi activer la couche exposée 10. Dans la suite, la couche 11 à base d'un matériau de formule SiₐY_{b}X_{c} est désignée couche SiₐY_{b}X_{c} 11 ou encore couche 11. On comprend que le plasma d'activation est une étape temporellement distincte de l'étape de dépôt de la couche SiₐY_{b}X_{c} 11, ces deux étapes ne sont pas simultanées.

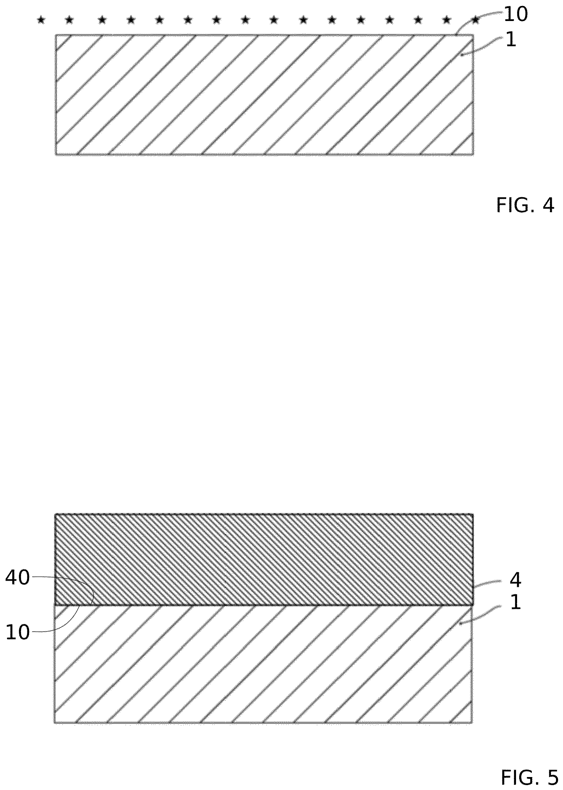

Le procédé est configuré pour déposer la couche SiₐY_{b}X_{c} 11 sur la couche exposée de sorte que, lors du traitement successif par le plasma d'activation 3 à base d'oxygène et/ou d'azote, le plasma d'activation 3 consomme au moins en partie la couche SiₐY_{b}X_{c} 11. Les réactions se déroulant lors de la consommation de la couche SiₐY_{b}X_{c} 11 induisent une activation de la couche exposée 10, par exemple illustrée en figure 4 dans laquelle les étoiles symbolisent l'activation de la couche exposée 10. La couche exposée 10 une fois activée présente notamment en surface des liaisons avec des atomes de fluor ou de chlore selon que la couche SiₐY_{b}X_{c} comprenne du fluor ou du chlore. Ces liaisons de surface permettent d'augmenter l'énergie de collage lors d'un assemblage de la structure avec un autre substrat.

Pour que la couche SiₐY_{b}X_{c} 11 soit au moins en partie consommée lors du traitement par le plasma d'activation 3, la couche SiₐY_{b}X_{c} 11 présente une densité de matière suffisamment faible. Les paramètres du dépôt de la couche SiₐY_{b}X_{c} 11 sont plus particulièrement choisis de façon à obtenir une densité de matière suffisamment faible pour que la couche SiₐY_{b}X_{c} soit au moins en partie consommée par le plasma d'activation, avec ou sans l'application d'une tension de polarisation V_{bias-substrat} au substrat. Les paramètres suivants sont particulièrement adaptés pour moduler la densité de matière de la couche SiₐY_{b}X_{c} 11 déposée : la température de dépôt, la pression dans la chambre de réaction et, le dépôt étant assisté par plasma, la puissance de la source RF du plasma. La personne du métier sait comment choisir ces paramètres pour atteindre la densité de matière permettant la consommation de la couche 11 déposée lors du traitement par le plasma d'activation. Par exemple, la température de dépôt de la couche SiₐY_{b}X_{c} 11 peut être sensiblement inférieure ou égale à 100 °C, et de préférence sensiblement comprise entre 20 °C et 80 °C. La puissance de la source RF du plasma peut être sensiblement inférieure ou égale à 300 W. Par exemple, pour cela la pression dans la chambre de réaction peut être sensiblement inférieure ou égale à 100 mTorr.

Suite à l'activation de la couche exposée 10, le procédé peut en outre comprendre une étape d'assemblage de la structure 1 avec un substrat ou une structure distinct(e). La couche exposée 10 peut être assemblée par collage direct à la couche exposée 40 du substrat 4 ou de la structure 4, comme par exemple illustré par la figure 5. La structure 4 peut faire partie d'un substrat. Ce substrat peut être formé uniquement de cette structure 4. De manière alternative, ce substrat peut comprendre une couche de support surmontée au moins d'une telle structure 4.

Un exemple de réalisation du procédé est décrit relativement aux figures 2 à 4.

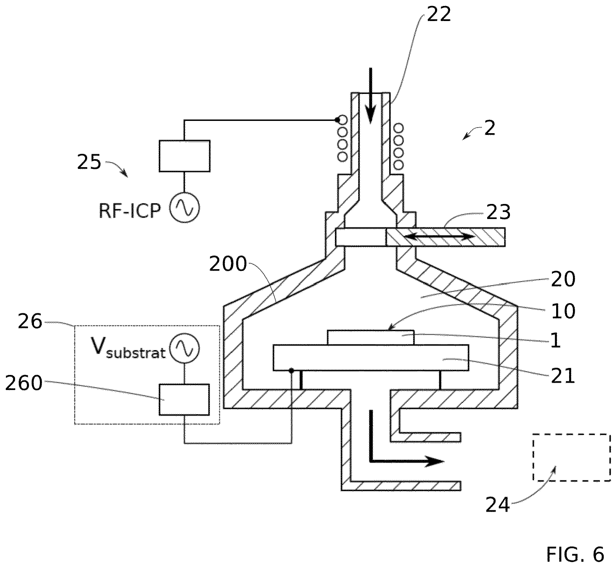

La structure 1 peut être fournie à l'intérieur de la chambre de réaction 20 d'un réacteur 2, par exemple un réacteur plasma et notamment un réacteur RIE, décrit plus en détail ultérieurement en référence à la figure 6.

La structure 1 étant placée dans la chambre de réaction 20, le procédé peut comprendre le dépôt de la couche SiₐY_{b}X_{c} 11, comme par exemple illustré par la figure 2 La couche SiₐY_{b}X_{c} 11 est alors déposée sur, et de préférence directement en contact avec, la couche exposée 10.

Le procédé comprend ensuite le traitement de la couche SiₐY_{b}X_{c} 11 par le plasma d'activation 3 à base d'oxygène et/ou d'azote, comme par exemple illustré par la figure 3. La couche SiₐY_{b}X_{c} 11 sur la couche exposée 10 est alors au moins en partie consommée. Le plasma d'activation réagit avec le matériau SiₐY_{b}X_{c}. Lors de cette réaction, le fluor ou le chlore contenu dans la couche SiₐY_{b}X_{c} 11 réagit avec la couche exposée 10 pour modifier ses liaisons chimiques de surface, ce qui induit son activation.

De préférence, le traitement par le plasma d'activation 3 est effectué de façon à consommer au moins 90% de la couche SiₐY_{b}X_{c} 11. De préférence, la couche SiₐY_{b}X_{c} 11 est totalement consommée. Ainsi, il ne reste plus de matériau SiₐY_{b}X_{c} 11 lors d'un assemblage ultérieur avec la couche exposée 40 d'un autre substrat 4, par exemple illustré par la figure 5. Le collage et/ou les propriétés du dispositif microélectronique résultant sont ainsi encore améliorés. La qualité de l'interface entre la couche exposée 10 et la couche exposée 40 après assemblage est améliorée. Pour cela on peut par exemple régler les paramètres du plasma, tels que le débit de précurseur(s) injecté(s), la puissance de la source, la pression dans la chambre de réaction 20, la tension d'auto-polarisation et notamment une tension de polarisation appliquée au substrat, la température du substrat.

Les propriétés de la couche exposée 10 après traitement par le plasma d'activation 3 peuvent être analysée par une caractérisation de la couche exposée 10, par exemple par analyse par spectrométrie photoélectronique X (communément abrégé XPS, de l'anglais *X-Ray photoelectron spectrometry*)*.* La couche exposée 10 une fois activée présente notamment en surface des liaisons avec des atomes de fluor ou de chlore selon que la couche SiₐY_{b}X_{c} comprenne du fluor ou du chlore. A titre d'exemple, après traitement par un plasma d'activation 3 à base d'O₂, la couche exposée 10 à base de silicium, sur laquelle a préalablement été déposé un dépôt avec le précurseur SiF₄ en combinaison avec O₂, peut présenter une surface de type SiₐO_{b}F_{c} dans le cas d'un substrat Silicium-sur-isolant (communément abrégé SOI, de l'anglais *Silicon-on-Insulator*)*.* Selon un autre exemple, après traitement par un plasma d'activation 3 à base de N₂, la couche exposée 10 à base de silicium, sur laquelle a préalablement été déposé un dépôt avec le précurseur SiF₄ en combinaison avec O₂, peut présenter une surface de type SiₐO_{d}F_{c}N_{b} dans le cas d'un substrat Silicium-sur-isolant, avec d un entier positif non nul. Selon cet exemple, le dépôt de la couche SiₐY_{b}X_{c} 11 et le traitement par le plasma d'activation 3 peuvent être faits dans la même chambre de réaction 20. De préférence, le substrat est laissé dans la chambre de réaction 20 entre le dépôt de la couche SiₐY_{b}X_{c} 11 et le traitement par le plasma d'activation 3. La présence d'impureté sur la couche SiₐY_{b}X_{c} 11 et dans la couche exposée 10 est ainsi mieux contrôlée, et de préférence évitée.

La gravure de la couche exposée 10 est limitée, et de préférence évitée, tout en apportant une source de fluor ou de chlore sur la couche exposée 10, pour l'activation de la couche exposée lors du traitement par le plasma d'activation 3.

Au moins l'un parmi le dépôt de la couche SiₐY_{b}X_{c} 11 et le traitement par le plasma d'activation 3 peuvent être répétés plusieurs fois. Plusieurs agencements d'étapes peuvent par exemple être prévus. On peut prévoir par exemple que, suite à la fourniture de la structure dans la chambre de réaction 20, le dépôt de la couche SiₐY_{b}X_{c} 11 puis le traitement par le plasma d'activation soient répétés plusieurs fois.

Le dépôt de la couche SiₐY_{b}X_{c} 11 est maintenant décrit plus en détail. Selon un exemple le dépôt de la couche SiₐY_{b}X_{c} 11 est un dépôt chimique à partir d'au moins un précurseur gazeux. L'au moins un précurseur gazeux peut comprendre les éléments silicium, chlore ou fluor, et oxygène ou azote. Selon un exemple, au moins un précurseur peut comprendre les éléments silicium et chlore ou fluor, et au moins un précurseur distinct peut comprendre l'élément azote et/ou oxygène. Par exemple, un précurseur gazeux est choisi parmi SiF₄ et SiCl₄. Un autre précurseur peut être choisi parmi O₂ et N₂. De préférence, la quantité de précurseur comprenant les éléments silicium et chlore ou fluor, par exemple le débit, par rapport à la quantité du ou des autre(s) précurseur(s) comprenant l'élément azote et/ou oxygène est sensiblement comprise entre 0,5 et 3. Par exemple, le ratio SiF₄/O₂ est sensiblement compris entre 0,5 et 3. Cela permet d'améliorer le contrôle du dépôt, et notamment de contrôler l'épaisseur et la densité de matière de la couche SiₐY_{b}X_{c} 11.

Le dépôt de la couche SiₐY_{b}X_{c} 11 peut comprendre une injection du ou des précurseur(s) gazeux, éventuellement en mélange avec d'autres précurseurs et/ou un ou des gaz neutres, tel que l'hélium ou l'argon.

Selon un exemple, lors du dépôt, le débit de précurseur(s) injecté(s) est sensiblement compris entre 5 et 500 sccm (unité de centimètres cubes standards par minutes, abrégée de l'anglais *Standard Cubic Centimeters per Minute,* et couramment employée dans le domaine pour mesurer le débit d'un gaz). Selon un exemple, le débit de précurseur(s) injecté(s) comprenant les éléments silicium et chlore ou fluor est sensiblement inférieur ou égal à 500 sccm, de préférence sensiblement inférieur ou égal à 200 sccm, et/ou sensiblement supérieur ou égal à 70 sccm. De préférence, le débit de précurseur(s) injecté(s) comprenant l'élément azote et/ou oxygène est sensiblement inférieur ou égal à 150 sccm. La pression peut être sensiblement comprise entre 10 mTorr et 100 mTorr (avec 1 Torr égal environ à 133,322 pascals (Pa) dans le système international des unités). Les débits et pression sont notamment choisis afin de contrôler la vitesse de dépôt et d'obtenir une bonne uniformité de la couche 11 déposée.

La température dans la chambre de réaction 20, de préférence la température de la structure ou de façon équivalente du substrat, lors du dépôt de la couche 11, peut être comprise entre sensiblement 10°C et 100°C. De préférence, pour limiter la densité de la couche SiₐY_{b}X_{c}, la température dans la chambre de réaction 20 est sensiblement inférieure ou égale à 100°C, et de préférence sensiblement comprise entre 20°C et 80°C. La température dans la chambre de réaction peut être la température des parois de la chambre 20 et/ou la température du porte-échantillon 21.

La puissance de la source plasma peut être comprise entre 200 W et 3000 W lors du dépôt de la couche 11. De préférence, pour limiter la densité de la couche SiₐY_{b}X_{c}, la puissance de la source plasma peut être sensiblement inférieure ou égale à 300 W.

A titre d'exemple non limitatif, lors du dépôt de la couche 11, un précurseur SiF₄ est injecté à un débit sensiblement égal à 100 sccm, en complément de O₂ à un débit de 150 sccm, à une pression de 10mTorr et une puissance RF du plasma Pₛ₋ₚₗₐₛₘₐ de 300W. Notons que ces paramètres peuvent être adaptés selon l'épaisseur souhaitée de la couche SiₐY_{b}X_{c}.

Le dépôt de la couche SiₐY_{b}X_{c} 11 peut être configuré de sorte que la couche SiₐY_{b}X_{c} 11 présente une épaisseur sensiblement supérieure ou égale à 1 nm, de préférence à 2 nm. Lors du développement de l'invention, il a été mis en évidence que cette épaisseur permettait une activation suffisante pour le collage ultérieur. Le dépôt de la couche SiₐY_{b}X_{c} 11 peut être configuré de sorte que la couche SiₐY_{b}X_{c} 11 présente une épaisseur sensiblement inférieure ou égale à 10 nm, de préférence à 4 nm. Le temps nécessaire au dépôt de la couche est ainsi limité, tout en permettant d'obtenir une activation suffisante pour le collage ultérieur. Le dépôt de la couche SiₐY_{b}X_{c} 11 peut être configuré de sorte que la couche SiₐY_{b}X_{c} 11 présente une épaisseur sensiblement comprise entre1 nm et 10 nm, et de préférence entre 2 nm et 4 nm.

Le traitement par le plasma d'activation 3 est maintenant décrit plus en détail. Le traitement par le plasma d'activation 3 peut comprendre une injection d'au moins un gaz dans la chambre de réaction 20 et une formation du plasma d'activation 3 à partir du gaz. Le plasma d'activation 3 est à base de l'un au moins parmi de l'oxygène et de l'azote pour réagir avec la couche SiₐY_{b}X_{c} 11. Par exemple, l'au moins un gaz injecté comprend du dioxygène et/ou du diazote. Le gaz peut être injecté en mélange avec un ou plusieurs gaz neutres, par exemple de l'hélium ou de l'argon. Selon un exemple, le débit de gaz injecté(s) est sensiblement compris entre 5 et 200 sccm. La pression dans la chambre de réaction peut être sensiblement comprise entre 5 mTorr et 200 mTorr (avec 1 Torr égal environ à 133,322 pascals (Pa) dans le système international des unités). La température dans la chambre de réaction, de préférence la température du substrat, lors du plasma d'activation, peut être comprise entre sensiblement 10°C et 100 °C. La puissance de la source plasma peut être comprise entre 200 W et 3000 W lors du plasma d'activation.

Le traitement par plasma d'activation 3 peut être continu. Selon un exemple alternatif, le traitement par plasma d'activation peut être pulsé. Durant la formation du plasma continu ou pulsé, les gaz sont de préférence injectés en continu.

Lors du traitement par le plasma d'activation 3 pulsé, le plasma pulsé peut être obtenu en faisant fonctionner par intermittence, de préférence périodiquement, la source du plasma et/ou la polarisation V_{bias-substrat} appliquée à la structure. L'application du plasma sur la structure est ainsi fractionnée dans le temps.

Selon un exemple, la tension d'auto-polarisation V_{bias-substrat} appliquée à la structure est pulsée, c'est-à-dire que l'application de la tension de polarisation comprend une succession alternativement d'application et de moindre application de la tension de polarisation à la structure. Selon un exemple, l'application de la tension de polarisation comprend une succession alternativement d'application et de non-application de la tension de polarisation à la structure. Selon un exemple, en alternance, une tension de polarisation V_{bias-substrat}1 et une tension de polarisation V_{bias-substrat}2 sont appliquées à la structure successivement, avec |V_{bias-substrat}2| < |V_{bias-substrat}1|, et de préférence |V_{bias-substrat1|} ≥ 5* |V_{bias-substrat}2| et plus préférablement |V_{bias-substrat}1| ≥ 10*|V_{bias-substrat}2|. De préférence, successivement en alternance, une tension d'auto-polarisation V_{bias-substrat}1 est appliquée à la structure et aucune tension d'auto-polarisation n'est appliquée à la structure. Lorsqu'aucune tension d'auto- polarisation V_{bias-substrat}2 n'est volontairement appliquée à la structure 1, notons qu'une tension de polarisation résiduelle peut être appliquée à la structure, notamment en raison de phénomène de gaine dans le plasma. |V_{bias-substrat}2| peut alors être sensiblement égal à 20V, et plus particulièrement sensiblement égal à 15V. Le fait que le traitement plasma 3 est pulsé permet une plus grande fenêtre de paramètres pour minimiser la gravure de la couche exposée tout en permettant son activation.

Comme dit précédemment, le traitement par plasma d'activation 3 comprend une injection d'au moins un gaz dans la chambre de réaction 20 et une formation d'un plasma à partir de ce gaz. Le traitement peut en outre comprendre plusieurs cycles, chaque cycle comprenant une alternance d'une purge et de la formation d'un plasma, et ce cycle étant répété plusieurs fois lors du traitement. Ici aussi, l'application du plasma sur le substrat est fractionnée dans le temps. Ce traitement est donc désigné par le terme de plasma cyclique, par opposition à un traitement où le nettoyage est effectué par l'application d'un plasma de façon continue.

Le traitement par plasma d'activation 3 peut comprendre au moins un et de préférence plusieurs cycles. Chaque cycle comprend au moins deux, et de préférence trois, étapes principales. Chaque cycle peut comprendre une étape habituellement qualifiée de purge. La purge a pour fonction d'évacuer les espèces gazeuses éventuellement présentes dans la chambre de réaction 20, par exemple d'évacuer les sous-produits réactionnels suite au traitement par plasma. Selon un exemple, dans le cycle, la purge est réalisée avant la formation du plasma. Ainsi, la composition du plasma formé est mieux contrôlée, pour s'assurer de la qualité du plasma obtenu. Cette purge consiste généralement à injecter dans la chambre de réaction 20 un gaz neutre tel que de l'argon ou de l'hélium.

Lors de la formation du plasma 3, une tension d'auto-polarisation, de préférence non-nulle, est appliquée. La tension d'auto-polarisation peut être appliquée à la chambre de réaction 20. Ainsi, l'énergie des ions du plasma d'activation peut être modulée pour améliorer l'efficacité du bombardement ionique sur la couche SiₐY_{b}X_{c} 11 et donc l'activation de la couche exposée, tout en limitant la gravure de la couche exposée 10. Pour cela, la tension d'auto-polarisation peut être strictement inférieure à 0. La valeur absolue de la tension d'auto-polarisation peut être sensiblement supérieure ou égale à 100 V, de préférence à 200 V. La valeur absolue de la tension d'auto-polarisation peut être sensiblement inférieure ou égale à 500 V, et de préférence sensiblement égale à 450 V pour une meilleure efficacité du bombardement ionique.

Le traitement par le plasma d'activation 3 peut être réalisé dans une chambre de réaction 20 d'un réacteur à gravure réactive (communément abrégé RIE, pour *Reactive Ion Etching*)*,* comprenant les réacteurs CCP et ICP détaillés ci-dessous. Selon un exemple, au moins le dépôt de la couche SiₐY_{b}X_{c} 11 est fait dans un réacteur RIE. De préférence, le dépôt de la couche SiₐY_{b}X_{c} 11 et le traitement par le plasma d'activation 3 est fait dans un réacteur RIE.

Le dépôt de la couche SiₐY_{b}X_{c} 11, et/ou le traitement par le plasma d'activation 3 peut/peuvent selon un premier exemple être réalisé(s) dans une chambre de réaction 20 d'un réacteur 2 plasma à couplage capacitif, habituellement qualifié par son acronyme CCP du terme anglais *Capacitively Coupled Plasma.* Dans un réacteur plasma à couplage capacitif, la tension d'auto-polarisation V_{bias-substrat} n'est pas dissociable de la puissance RF Pₛ₋ₚₗₐₛₘₐ fournie pour créer le plasma. Dans le cas d'un réacteur plasma de type CCP, la tension d'auto-polarisation est forcément non nulle. Les plasmas ainsi produits sont aptes à déposer une couche SiₐY_{b}X_{c} 11 lors de l'étape de dépôt, et effectuer le plasma d'activation 3.

Le dépôt de la couche SiₐY_{b}X_{c} 11, et/ou le traitement par le plasma d'activation 3 peut/peuvent selon un premier exemple être réalisé(s) dans une chambre de réaction 20 d'un réacteur 2 plasma à couplage inductif, habituellement qualifié par son acronyme ICP du terme anglais *Inductively Coupled Plasma.* Dans un réacteur plasma à couplage inductif, la tension d'auto-polarisation est générée par la puissance RF appliquée au niveau du porte-échantillon 21. Elle correspond donc à une tension de polarisation appliquée à la structure ou de façon équivalente au substrat V_{bias-substrat}. La puissance RF appliquée au niveau de la source 25 du plasma réacteur détermine quant à elle la densité ionique du plasma. V_{bias-substrat}. est ici différente et indépendante de V_{source} la tension de la source du plasma. L'avantage d'un réacteur plasma de type ICP est donc de pouvoir dissocier le bombardement ionique sur le substrat de la densité du plasma. Un plasma à couplage inductif sera préféré, qui permet de contrôler indépendamment le V_{bias-substrat} par rapport à la puissance RF Pₛ₋ₚₗₐₛₘₐ de la source 25 du plasma pour un meilleur contrôle de la tension d'auto-polarisation, par dissociation de la tension appliquée au substrat et de la puissance RF du plasma Pₛ₋ₚₗₐₛₘₐ.

Ainsi, le bombardement ionique sur la couche SiₐY_{b}X_{c} 11 et la gravure de la couche exposée 10 peuvent être encore mieux contrôlés et de préférence minimisés. Par conséquent, le collage subséquent sera amélioré. En outre, la qualité de l'interface entre la couche exposée 10 et la couche exposée 40 après assemblage de la structure 1 et du substrat 4 est améliorée.

En pratique, comme par exemple illustré par la figure 6, la chambre de réaction 20 comprend un plateau de réception 21 du substrat ou aussi porte-échantillon. Selon un exemple, la tension de polarisation V_{bias-substrat} est appliquée au plateau 21. De préférence, la tension de polarisation V_{bias-substrat} est appliquée uniquement au plateau 21. Selon cet exemple, le plateau 21 est conducteur électriquement et la tension de polarisation V_{bias-substrat} est appliquée à ce plateau 21 par un dispositif de régulation de la tension 26 pour être transmise à la structure 1. Le dispositif de régulation de la tension 26 est par exemple configuré pour appliquer une puissance RF au niveau du porte échantillon.

Selon un exemple, la valeur absolue de la tension de polarisation |V_{bias-substrat}| appliquée est sensiblement inférieure ou égale à 500 V. La valeur absolue de la tension de polarisation |V_{bias-substrat}| appliquée peut être sensiblement supérieure ou égale à 50 V. On notera que cette tension de polarisation est bien plus faible que les tensions de polarisation habituellement utilisées pour réaliser des implantations par plasma dans un réacteur CCP. Selon un exemple, la tension de polarisation V_{bias-substrat} est appliquée uniquement durant le traitement par le plasma d'activation 3. Selon un exemple, la tension de polarisation V_{bias-substrat} est appliquée uniquement lors de la formation du plasma, durant le traitement par le plasma d'activation 3. Selon un exemple, une tension de polarisation V_{bias-substrat} est appliquée durant au moins 50% et de préférence au moins 70 % de la formation du plasma, durant le traitement par le plasma d'activation 3.

Selon un exemple, une tension de polarisation V_{bias-substrat} peut être appliquée à la structure lors du dépôt de la couche SiₐY_{b}X_{c} 11. Durant le dépôt, V_{bias-substrat} est de préférence inférieure ou égale à 100 V, de préférence comprise entre 0 et 50 V. Plus préférentiellement encore, aucune tension de polarisation n'est appliquée durant l'étape de dépôt. Le bombardement ionique est ainsi limité, ce qui limite encore le risque de gravure de la couche exposée 10.

Un réacteur ICP est maintenant décrit à titre d'exemple en référence à la figure 6. De manière relativement classique, le réacteur 2 comprend une entrée 22 des gaz permettant d'injecter à l'intérieur de la chambre 20 les gaz destinés à former la chimie du plasma ainsi que les gaz destinés aux phases de purge. La source plasma 25 est selon un exemple un dispositif de couplage par induction 25, dont une bobine est illustrée en figure 6, et qui permet la formation du plasma. La source plasma 25 peut être radiofréquence (abrégé RF-ICP sur la figure 6). Le réacteur 2 comprend également une valve 23 d'isolation de la chambre de réaction 20. Le réacteur 20 comprend également une pompe 24 configurée pour contrôler la pression à l'intérieur de la chambre de réaction 20 de façon synergique avec le débit des gaz injectés, et extraire les espèces présentes dans la chambre de réaction 20.

De manière avantageuse, ce réacteur 2 comprend un dispositif de polarisation 26 configuré pour permettre l'application de la tension de polarisation V_{bias-substrat} au plateau 21, par exemple via un générateur de puissance radiofréquence. Cette tension peut in fine être appliquée à la structure 1, tout au moins à sa face tournée au regard du plateau 21, que cette face soit électriquement conductrice ou non. Ce dispositif de polarisation 26 est de préférence distinct de la source plasma 25. Ce dispositif de polarisation 26 peut comprendre un dispositif de contrôle 260 configuré pour appliquer une tension alternative sur le plateau 21.

Selon cet exemple, le dispositif de polarisation 26 et la source plasma 25 sont configurés de sorte à pouvoir régler la tension de polarisation V_{bias-substrat} appliquée au plateau 21 indépendamment de la puissance RF Pₛ₋ₚₗₐₛₘₐ de la source 25 du plasma. V_{bias-substrat} et Pₛ₋ₚₗₐₛₘₐ peuvent être indépendantes. V_{bias-substrat} et Pₛ₋ₚₗₐₛₘₐ peuvent être contrôlées de manière indépendante.

Selon un exemple alternatif, lors de la formation du plasma d'activation 3, aucune tension V_{bias-substrat} n'est appliquée au substrat.

Exemples particuliers de réalisation.

Dans ces exemples, les paramètres expérimentaux sont les suivants :
- aucune tension de polarisation n'est appliquée à la structure 1
- la pression dans la chambre de réaction 20 est sensiblement égale à 10 mTorr,
- la durée de dépôt est de 5 secondes
- le débit de SiF₄ est sensiblement égal à 95 sccm,
- le débit d'Oz est sensiblement égal à 50 sccm, sauf indiqué autrement
- le débit d'argon est sensiblement égal à 475 sccm.

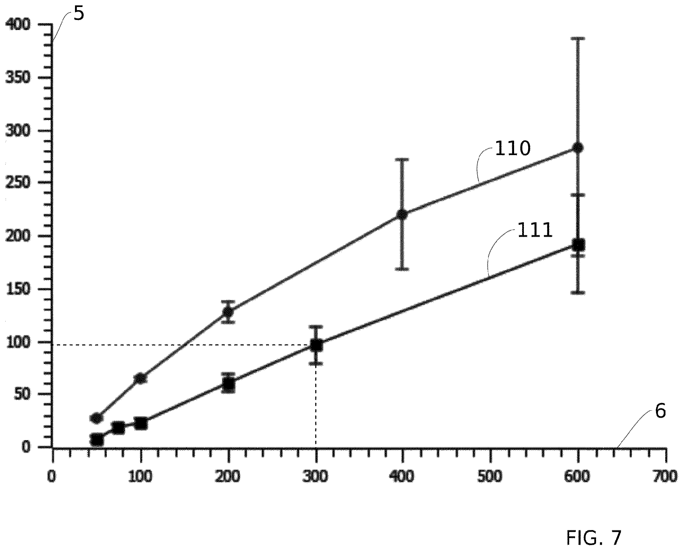

Les figures 7 à 9 décrivent l'influence de paramètres expérimentaux sur l'épaisseur en Å (10⁻¹⁰ m) 5 de la couche SiₐY_{b}X_{c} 11 pour :
- 110 : un dépôt d'une couche SiₐY_{b}X_{c} 11 sur une couche exposée de silice SiO₂.
- 111 : un dépôt d'une couche SiₐY_{b}X_{c} 11 sur une couche exposée de résine.

La figure 7 illustre l'influence de la puissance RF 6 de la source Pₛ₋ₚₗₐₛₘₐ. Pour obtenir une épaisseur inférieure ou égale à 10 nm (100 Å), Pₛ₋ₚₗₐₛₘₐ ≤ 300 W et de préférence ≤ 200 W, de préférence ≤ 150 W.

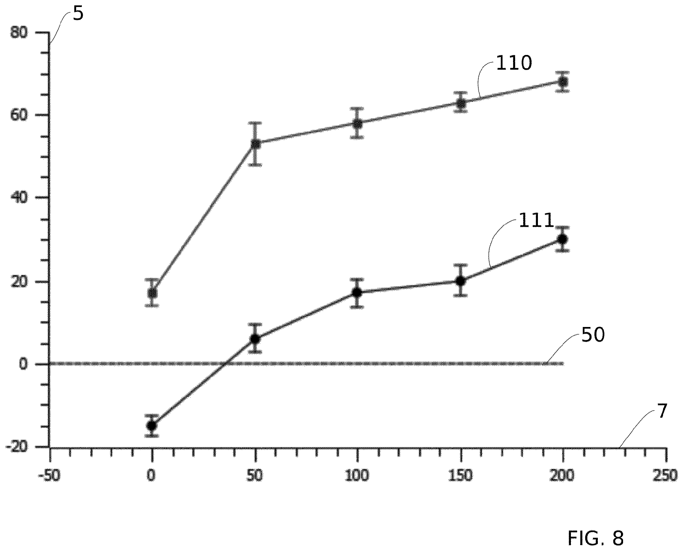

La figure 8 illustre l'influence du débit d'O₂ lors de l'étape de dépôt, pour un débit de SiF4 de 95 sccm. On observe une limite 50 entre le dépôt de la couche SiₐY_{b}X_{c} 11 et la gravure de la couche exposée 10. Pour ces paramètres et façon générale dans l'invention, le débit d'O₂ et/ou N₂ est choisi de façon à déposer la couche SiₐY_{b}X_{c} 11 sans gravée la couche exposée. De préférence, le débit d'O₂ est en outre inférieur ou égal à 150 sccm pour limiter l'épaisseur de la couche SiₐY_{b}X_{c} 11 déposée.

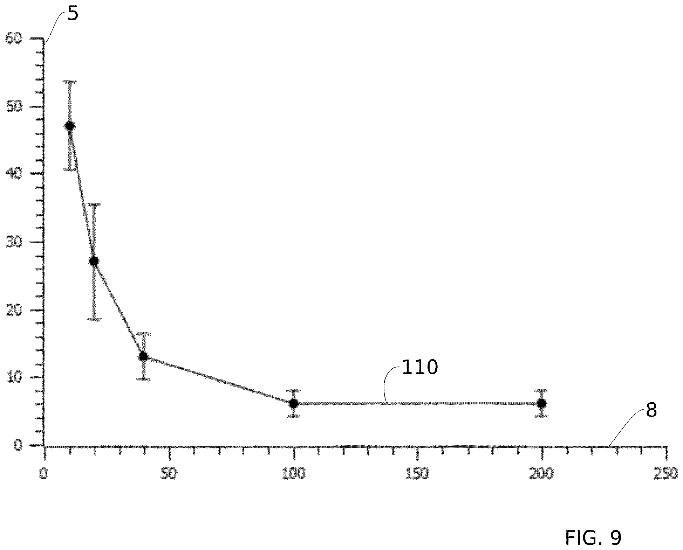

La figure 9 illustre l'influence de la pression dans la chambre de réaction 20. Plus la pression augmente, plus l'épaisseur déposée est faible. De préférence, on choisit une pression sensiblement comprise entre 10 mTorr et 100 mTorr.

Au vu de la description qui précède, il apparaît clairement que l'invention propose un procédé améliorant le collage direct sur un substrat, et notamment permettant de limiter la gravure de la couche exposée.

L'invention s'étend également aux modes de réalisation dans lesquels la structure est déposée sur un substrat à base de silicium.

Par ailleurs, dans les exemples décrits ci-dessus la structure est une couche. Néanmoins, tous les exemples, caractéristiques, étapes et avantages techniques mentionnés ci-dessus en référence à une structure formant une couche sont applicables à une structure ne formant pas une couche mais formant une structure ponctuelle, par exemple un relief en trois dimensions. La structure peut être une nanostructure ou comprendre une pluralité de nanostructures.

## Revendications

1. Procédé d'activation d'une couche exposée (10) d'une structure (1) comprenant :
• une fourniture d'une structure (1) comprenant une couche exposée (10),
• un dépôt, sur la couche exposée (10), d'une couche (11) à base d'un matériau de formule SiₐY_{b}X_{c}, dite couche SiₐY_{b}X_{c}, avec X choisi parmi le fluor F et le chlore CI, et Y choisi parmi l'oxygène O et l'azote N, a, b et c étant des entiers positifs non nuls,
• un traitement de la couche (11) SiₐY_{b}X_{c} par un plasma d'activation (3) à base de l'un au moins parmi de l'oxygène et de l'azote,
et dans lequel :
• les paramètres du dépôt de la couche (11) SiₐY_{b}X_{c} sont choisis de façon à obtenir une densité de matière suffisamment faible pour que la couche (11) SiₐY_{b}X_{c} soit au moins en partie consommée par le plasma d'activation (3).

2. Procédé selon la revendication précédente, dans lequel les paramètres choisis de façon à obtenir une densité de matière suffisamment faible pour que la couche (11) SiₐY_{b}X_{c} soit au moins en partie consommée par le plasma d'activation (3) sont pris parmi les paramètres suivants : la température de dépôt, la pression dans la chambre de réaction et, le dépôt étant assisté par plasma, la puissance d'une source du plasma.

3. Procédé selon l'une quelconque des revendications précédentes, dans lequel le traitement par le plasma d'activation (3) est effectué de sorte à consommer au moins 90% de la couche SiₐY_{b}X_{c} (11) déposée et de préférence toute la couche SiₐY_{b}X_{c} (11) déposée.

4. Procédé selon l'une quelconque des revendications précédentes, dans lequel le dépôt est configuré de sorte que la couche SiₐY_{b}X_{c} (11) présente une épaisseur inférieure ou égale à 10 nm, de préférence comprise en 2 et 4 nm.

5. Procédé selon l'une quelconque des revendications précédentes, dans lequel le traitement par le plasma d'activation (3) comprend l'application dans la chambre de réaction (2) d'une tension, dite tension d'auto-polarisation, de préférence la valeur absolue de la tension d'auto-polarisation est supérieure ou égale à 100 V et plus préférentiellement comprise entre 100 V et 500 V.

6. Procédé selon l'une quelconque des revendications précédentes, dans lequel le dépôt de la couche SiₐY_{b}X_{c} (11) comprend l'application dans la chambre de réaction (2) d'une tension, dite tension d'auto-polarisation, inférieure ou égale à 100 V, de préférence comprise entre 0 et 50 V, de préférence aucune tension d'auto-polarisation n'est appliquée durant ledit dépôt.

7. Procédé selon l'une quelconque des revendications précédentes, dans lequel la structure est fournie dans un réacteur (2) comprenant une chambre de réaction (20) à l'intérieur de laquelle la structure (1) est disposée pour au moins le dépôt de la couche SiₐY_{b}X_{c} (11), la température dans la chambre étant inférieure ou égale à 100 °C au moins pendant le dépôt de la couche SiₐY_{b}X_{c} (11), et de préférence sensiblement comprise entre 20°C et 80°C.

8. Procédé selon l'une quelconque des revendications précédentes, dans lequel la structure est fournie dans un réacteur (2) de gravure réactive, le réacteur (2) comprenant une chambre de réaction (20) à l'intérieur de laquelle la structure (1) est disposée pour au moins le dépôt de la couche SiₐY_{b}X_{c} (11), de préférence :
• le dépôt de la couche SiₐY_{b}X_{c} (11) et le traitement par le plasma d'activation (3) sont réalisés dans une chambre de réaction (20) d'un réacteur (2) plasma à couplage capacitif, ou
• le dépôt de la couche SiₐY_{b}X_{c} (11) et le traitement par le plasma d'activation (3) sont réalisés dans une chambre de réaction (20) d'un réacteur (2) plasma à couplage inductif et plus préférentiellement alors une tension de polarisation Vbias-substrat est appliquée à la structure (1).

9. Procédé selon l'une quelconque des revendications précédentes, dans lequel le plasma d'activation (3) est pulsé.

10. Procédé selon l'une quelconque des revendications précédentes, dans lequel le dépôt de la couche SiₐY_{b}X_{c} (11) est un dépôt chimique à partir d'au moins un précurseur gazeux, de préférence le dépôt est assisté par plasma, l'au moins un précurseur gazeux comprend au moins les éléments silicium, l'un parmi le fluor et le chlore, et l'un parmi l'oxygène et l'azote, de préférence l'au moins un précurseur gazeux étant choisi parmi le groupe constitué de SiF₄ et SiCl₄ en combinaison avec O₂ ou N₂.

11. Procédé selon l'une quelconque des revendications précédentes, dans lequel le traitement par le plasma d'activation (3) comprend une injection d'au moins un gaz dans une chambre de réaction (20) d'un réacteur (2) plasma et une formation du plasma d'activation (3) à partir dudit gaz dans la chambre de réaction (20), l'au moins un gaz comprenant du dioxygène ou du diazote.

12. Procédé selon l'une quelconque des revendications précédentes, dans lequel la couche exposée (10) est à base de silicium, par exemple la couche exposée (10) est à base ou faite d'un oxyde de silicium, d'un nitrure de silicium ou de silicium.

13. Procédé selon l'une quelconque des revendications précédentes, dans lequel au moins au moins l'un parmi le dépôt de la couche SiₐY_{b}X_{c} (11) et le traitement par le plasma d'activation (3) peuvent être répétés plusieurs fois.

14. Procédé de collage d'une couche exposée (10) d'une structure (1) avec une couche exposée (40) d'un substrat (4) distinct, le procédé comprenant :
• l'activation de la couche exposée (10) de la structure (1) en mettant en oeuvre le procédé selon l'une quelconque des revendications précédentes,
• la mise en contact de la couche exposée (10) de la structure avec la couche exposée du substrat (4) distinct.

## Patentansprüche

1. Verfahren zur Aktivierung einer belichteten Schicht (10) einer Struktur (1), das Folgendes umfasst:
· ein Einbringen einer Struktur (1), die eine belichtete Schicht (10) umfasst,
· ein Abscheiden auf der belichteten Schicht (10) einer Schicht (11), die auf einem Material mit der Formel SiₐY_{b}X_{c} basiert, SiₐY_{b}X_{c}-Schicht genannt, wobei X ausgewählt ist aus Fluor F und Chlor CI, und Y ausgewählt ist aus Sauerstoff O und Stickstoff N, wobei a, b und c positive Ganzzahlen oder nicht gleich null sind,
ein Behandeln der SiₐY_{b}X_{c}-Schicht (11) durch ein Aktivierungsplasma (3) basierend auf mindestens einem von Sauerstoff und Stickstoff, und wobei:
• die Abscheidungsparameter der SiₐY_{b}X_{c}-Schicht (11) derart ausgewählt werden, dass eine ausreichend geringe Materialdichte erhalten wird, damit die SiₐY_{b}X_{c}-Schicht (11) mindestens zum Teil durch das Aktivierungsplasma (3) verbraucht wird.

2. Verfahren nach dem vorstehenden Anspruch, wobei die Parameter, die ausgewählt werden, um eine ausreichend geringe Materialdichte zu erhalten, damit die SiₐY_{b}X_{c}-Schicht (11) mindestens zum Teil durch das Aktivierungsplasma (3) verbraucht wird, aus den folgenden Parametern genommen werden: Abscheidungstemperatur, Druck in der Reaktionskammer und, da das Abscheiden durch Plasma unterstützt wird, Leistung einer Plasmaquelle.

3. Verfahren nach einem der vorstehenden Ansprüche, wobei das Behandeln durch das Aktivierungsplasma (3) derart ausgeführt wird, dass mindestens 90 % der abgeschiedenen SiₐY_{b}X_{c}-Schicht (11) und bevorzugt die gesamte abgeschiedene SiₐY_{b}X_{c}-Schicht (11) verbraucht wird.

4. Verfahren nach einem der vorstehenden Ansprüche, wobei das Abscheiden dazu konfiguriert ist, dass die SiₐY_{b}X_{c}-Schicht (11) eine Dicke kleiner oder gleich 10 nm, bevorzugt zwischen 2 und 4 nm aufweist.

5. Verfahren nach einem der vorstehenden Ansprüche, wobei das Behandeln durch das Aktivierungsplasma (3) das Anlegen in der Reaktionskammer (2) einer Spannung, automatische Gittervorspannung genannt, umfasst, wobei der Absolutwert der automatischen Gittervorspannung bevorzugt größer oder gleich 100 V ist und bevorzugt zwischen 100 V und 500 V liegt.

6. Verfahren nach einem der vorstehenden Ansprüche, wobei das Abscheiden der SiₐY_{b}X_{c}-Schicht (11) das Anlegen in der Reaktionskammer (2) einer Spannung, automatische Gitterspannung genannt, kleiner oder gleich 100 V, bevorzugt zwischen 0 und 50 V umfasst, wobei bevorzugt keine automatische Gitterspannung angelegt wird.

7. Verfahren nach einem der vorstehenden Ansprüche, wobei die Struktur in einen Reaktor (2) eingebracht wird, der eine Reaktionskammer (20) umfasst, in deren Innerem die Struktur (1) mindestens für das Abscheiden der SiₐY_{b}X_{c}-Schicht (11) angeordnet wird, wobei die Temperatur in der Kammer mindestens während des Abscheidens der SiₐY_{b}X_{c}-Schicht (11) kleiner oder gleich 100 °C ist und bevorzugt zwischen 20 °C und 80 °C liegt.

8. Verfahren nach einem der vorstehenden Ansprüche, wobei die Struktur in einen Reaktor (2) zum reaktiven Ätzen eingebracht wird, wobei der Reaktor (2) eine Reaktionskammer (20) umfasst, in deren Innerem die Struktur (1) für mindestens das Abscheiden der SiₐY_{b}X_{c}-Schicht (11) angeordnet wird, wobei bevorzugt:
• das Abscheiden der SiₐY_{b}X_{c}-Schicht (11) und das Behandeln durch das Aktivierungsplasma (3) in einer Reaktionskammer (20) eines kapazitiv gekoppelten Plasmareaktors (2) realisiert werden, oder
• das Abscheiden der SiₐY_{b}X_{c}-Schicht (11) und das Behandeln durch das Aktivierungsplasma (3) in einer Reaktionskammer (20) eines induktiv gekoppelten Plasmareaktors (2) realisiert werden, und wobei bevorzugter eine Polarisationsspannung Vbias-substrat an die Struktur (1) angelegt wird.

9. Verfahren nach einem der vorstehenden Ansprüche, wobei das Aktivierungsplasma (3) gepulst wird.

10. Verfahren nach einem der vorstehenden Ansprüche, wobei das Abscheiden der SiₐY_{b}X_{c}-Schicht (11) eine chemische Abscheidung ausgehend von mindestens einem gasförmigen Vorläufer ist, das Abscheiden bevorzugt durch Plasma unterstützt wird, der mindestens eine gasförmige Vorläufer mindestens die Elemente Silizium, eines von Fluor und Chlor und eines von Sauerstoff und Stickstoff umfasst, wobei bevorzugt mindestens ein gasförmiger Vorläufer aus der Gruppe ausgewählt wird, die aus SiF₄ und SiCl₄ in Kombination mit O₂ und N₂ ausgewählt wird.

11. Verfahren nach einem der vorstehenden Ansprüche, wobei das Behandeln durch das Aktivierungsplasma (3) ein Einspritzen mindestens eines Gases in eine Reaktionskammer (20) eines Plasmareaktors (2) und ein Bilden des Aktivierungsplasmas (3) ausgehend von dem Gas in der Reaktionskammer (20) umfasst, wobei das mindestens eine Gas Disauerstoff oder Distickstoff umfasst.

12. Verfahren nach einem der vorstehenden Ansprüche, wobei die belichtete Schicht (10) auf Silizium basiert, die belichtete Schicht (10) beispielsweise auf einem Siliziumoxid, einem Siliziumnitrid oder Silizium basiert oder daraus hergestellt ist.

13. Verfahren nach einem der vorstehenden Ansprüche, wobei mindestens eines des Abscheidens der SiₐY_{b}X_{c}-Schicht (11) und des Behandelns durch das Aktivierungsplasma (3) mehrmals wiederholt werden kann.

14. Verfahren zum Kleben einer belichteten Schicht (10) einer Struktur (1) mit einer belichteten Schicht (40) eines getrennten Substrats (4), wobei das Verfahren Folgendes umfasst:
• das Aktivieren der belichteten Schicht (10) der Struktur (1), indem das Verfahren nach einem der vorstehenden Ansprüche umgesetzt wird,
• das Inkontaktbringen der belichteten Schicht (10) der Struktur mit der belichteten Schicht des getrennten Substrats (4).

## Claims

1. Method of activating an exposed layer (10) of a structure (1) comprising:
- a provision of a structure (1) comprising an exposed layer (10),
- a deposition, on the exposed layer (10), of a layer (11) with the basis of a material of formula SiₐY_{b}X_{c}, called layer SiₐY_{b}X_{c}, with X chosen from among fluorine F and chlorine Cl, and Y chosen from among oxygen O and nitrogen N, a, b and c being non-zero positive integers,
- a treatment of the layer (11) SiₐY_{b}X_{c} by an activation plasma (3) with the basis of at least one from among oxygen and nitrogen,
and wherein:
- the parameters of the deposition of the layer (11) SiₐY_{b}X_{c} are chosen so as to obtain a sufficiently low material density, such that the layer (11) SiₐY_{b}X_{c} is at least partially consumed by the activation plasma (3).

2. Method according to the preceding claim, wherein the parameters chosen so as to obtain a sufficiently low material density such that the layer (11) SiₐY_{b}X_{c} is at least partially consumed by the activation plasma (3) are taken from among the following parameters: the deposition temperature, the pressure in the reaction chamber and, the deposition being plasma-enhanced, the power of a source of the plasma.

3. Method according to any one of the preceding claims, wherein the treatment by the activation plasma (3) is performed so as to consume at least 90% of the deposited layer SiₐY_{b}X_{c} (11) and preferably the entire deposited layer SiₐY_{b}X_{c} (11).

4. Method according to any one of the preceding claims, wherein the deposition is configured such that the layer SiₐY_{b}X_{c} (11) has a thickness less than or equal to 10nm, preferably of between 2 and 4nm.

5. Method according to any one of the preceding claims, wherein the treatment by the activation plasma (3) comprises the application in the reaction chamber (2) of a voltage, called self-biasing voltage, preferably the absolute value of the self-biasing voltage is greater than or equal to 100V and more preferably of between 100V and 500V.

6. Method according to any one of the preceding claims, wherein the deposition of the layer SiₐY_{b}X_{c} (11) comprises the application in the reaction chamber (2) of a voltage, called self-biasing voltage, less than or equal to 100V, preferably of between 0 and 50V, preferably no self-biasing voltage is applied during said deposition.

7. Method according to any one of the preceding claims, wherein the structure is provided in a reactor (2) comprising a reaction chamber (20) inside which the structure (1) is disposed for at least the deposition of the layer SiₐY_{b}X_{c} (11), the temperature in the chamber being less than or equal to 100°C at least during the deposition of the layer SiₐY_{b}X_{c} (11), and preferably substantially between 20°C and 80°C.

8. Method according to any one of the preceding claims, wherein the structure is provided in a reactive etching reactor (2), the reactor (2) comprising a reaction chamber (20) inside which the structure (1) is disposed for at least the deposition of the layer SiₐY_{b}X_{c} (11), preferably:
- the deposition of the layer SiₐY_{b}X_{c} (11) and the treatment by the activation plasma (3) are performed in a reaction chamber (20) of a capacitive coupling plasma reactor (2), or
- the deposition of the layer SiₐY_{b}X_{c} (11) and the treatment by the activation plasma (3) are performed in a reaction chamber (20) of an inductive coupling plasma reactor (2), and more preferably thus a bias voltage Vbias-substrate is applied to the structure (1).

9. Method according to any one of the preceding claims, wherein the activation plasma (3) is pulsed.

10. Method according to any one of the preceding claims, wherein the deposition of the layer SiₐY_{b}X_{c} (11) is chemical deposition from at least one gaseous precursor, preferably the deposition is plasma-enhanced, the at least one gaseous precursor comprises at least the silicon elements, one from among fluorine and chlorine, and one from among oxygen and nitrogen, preferably at least one gaseous precursor being chosen from among the group consisting of SiF₄ and SiCl₄ combined with O₂ or N₂.

11. Method according to any one of the preceding claims, wherein the treatment by the activation plasma (3) comprises an injection of at least one gas in a reaction chamber (20) of a plasma reactor (2) and a formation of the activation plasma (3) from said gas in the reaction chamber (20), the at least one gas comprising dioxygen or dinitrogen.

12. Method according to any one of the preceding claims, wherein the exposed layer (10) is silicon-based, for example the exposed layer (10) is with the basis of or made of a silicon oxide, a silicon nitride or silicon.

13. Method according to any one of the preceding claims, wherein at least one from among the deposition of the layer SiₐY_{b}X_{c} (11) and the treatment by the activation plasma (3) can be repeated several times.

14. Method for gluing an exposed layer (10) of a structure (1) with an exposed layer (40) of a distinct substrate (4), the method comprising:
- the activation of the exposed layer (10) of the structure (1) by implementing the method according to any one of the preceding claims,
- the contacting of the exposed layer (10) of the structure with the exposed layer of the distinct substrate (4).
